# EUROPEAN PATENT APPLICATION

(11) **EP 1 617 399 A2**
(43) Date of publication of application: **18.01.2006**
(21) Application number: 05015064.8
(22) Date of filing: 12.07.2005
(51) Int. Cl.: G09G 3/32

(54) **Organic electroluminescent display device**

(30) Priority: 12.07.2004 JP 2004205256
(71) Applicant: SANYO ELECTRIC CO., LTD., Moriguchi-shi, Osaka 570-8677 (JP)
(72) Inventor: Ogawa, Takashi, Anpachi-cho, Anpachi-gun Gifu 503-0115 (JP)
(74) Representative: Glawe, Delfs, Moll

(57) **Abstract**

A photosensor (200) is disposed in each pixel (30), and the brightness is adjusted for each pixel (30) depending on the light quantity of an organic EL element (7). The adjustment of brightness is realized by making the current amount of a pixel (30) with a high brightness small in accordance with a pixel (30) with a small light emission amount. Thus, low power consumption can be achieved, and the unevenness of brightness can be corrected. By disposing the photosensor (200) to configure a photoreceptor circuit (205) in each pixel (30), the unevenness of brightness is corrected. Further, it becomes possible to correct brightness in a brightness half-life. Hence, a longer lifetime can be achieved.

## Description

### BACKGROUND OF THE INVENTION

### Field of the Invention

The present invention relates to an organic electroluminescent (EL) display device, particularly to an organic EL display device capable of adjusting the unevenness of brightness in each pixel in a display unit.

### Description of the Related Art

Since an organic EL element is self-luminous, a backlight necessary for a liquid crystal display device is not required. Thus, it is optimal to make the display device thinner. In addition, the organic EL element has no limit to a viewing angle. Therefore, the organic EL element is largely expected to become commercially practical as a display device of the next generation.

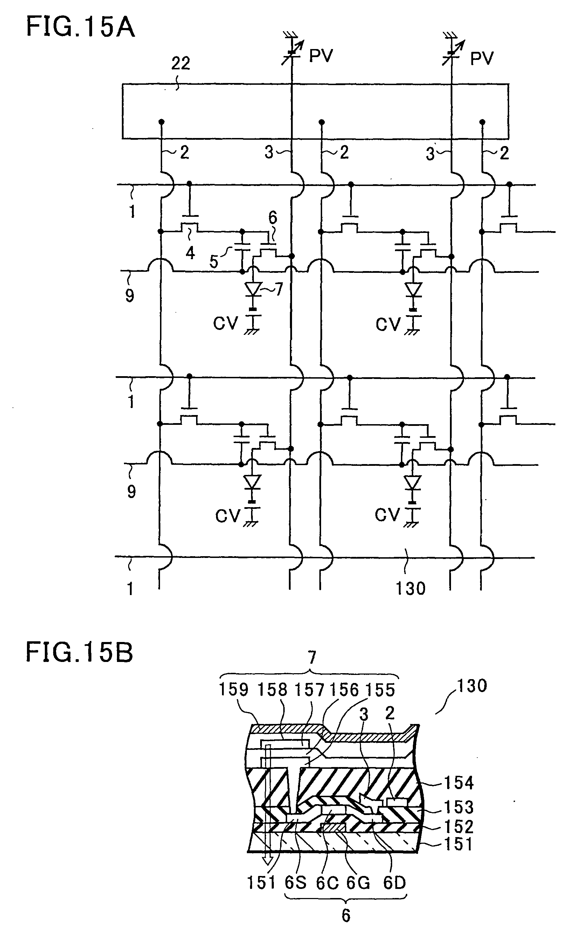

Incidentally, there are two kinds of drive methods of the organic EL display device: a passive type of a simple matrix and an active type using TFTs. In the active type, a circuit configuration shown in Fig. 15A is generally used. Fig. 15A is a circuit schematic diagram of a display unit of an organic EL display device, and Fig. 15B is a cross-sectional view of a part of one pixel.

As shown in Fig. 15A, a plurality of gate lines 1 extending in the row direction, are disposed, and a plurality of drain lines 2 and first power supply lines 3 are disposed in the column direction to cross the gate lines 1.

Selection TFTs 4 are connected respectively to each intersection of the gate lines 1 and the drain lines 2. A gate of the selection TFT 4 is connected to the gate line 1, and a drain of the selection TFT 4 is connected to the drain line 2. A source of the selection TFT 4 is connected to a hold capacitor 5 and a gate of a drive TFT 6.

A drain of the drive TFT 6 is connected to the first power supply line 3, and a source of the drive TFT 6 is connected to an anode of an organic EL element 7. The counter electrode of the hold capacitor 5 is connected to a second power supply line 9 extending in the column direction.

The gate lines 1 are connected to an unillustrated V scanner. Gate signals are sequentially applied to each of the gate lines 1 by use of the V scanner. The gate signals are binary signals of on or off. In the case of on, the voltage is a positive predetermined voltage, and in the case of off, the voltage is 0 V. The V scanner turns on a gate signal of a selected predetermined gate line out of the plurality of gate lines 1 connected thereto. When the gate signal is on, all the selection TFTs 4 which are connected to the selected gate line 1 are turned on. Therefore, the drain lines 2 and the gates of the drive TFTs 6 are connected through the selection TFTs 4.

Data signals determined depending on an image to be displayed are outputted from an H scanner 22 to the drain lines 2. In addition to being inputted to the gates of the drive TFTs 6, the data signals are charged in the hold capacitor 5.

The drive TFT 6 is connected to the first power supply line 3 and the organic EL element 7 with conductivity depending on the magnitude of the data signals. As a result, a current in response to the data signal is supplied from the first power supply line 3 through the drive TFT 6 to the organic EL element 7. Accordingly, the organic EL element 7 emits light with a brightness in response to the data signals.

The hold capacitor 5 has a capacitance between other electrodes such as the second power supply line 9 or the first power supply line 3, and can store the data signals for a certain period of time.

Even after the V scanner selects another gate line 1, the previously selected gate line 1 becomes unselected, and the selection TFTs are turned off, the data signals are held by the hold capacitors 5 during one vertical scanning period. In the meantime, the drive TFTs 6 hold the conductivity, thus enabling the organic EL elements 7 to continue to emit light with the brightness.

As shown in Fig. 15B, in a pixel 130 of the organic EL display device, the plurality of drive TFTs 6 are disposed on a glass substrate 151. The drive TFT 6 has a structure in which a gate electrode 6G is opposed to a source 6S, a channel 6c and a drain 6D with an interlayer insulation film 152 interposed therebetween. The example shown here has a bottom gate structure in which the gate electrode 6G is disposed below the channel 6C.

An interlayer insulation film 153 is formed on the drive TFTs 6, and thereon the drain lines 2 and the first power supply lines 3 are disposed. The first power supply line 3 is connected to the drain 6D of the drive TFT 6 through a contact. On the top of them, a planarizing insulation film 154 is formed, and the organic EL element 7 is disposed in each of pixels on the planarizing insulation film 154.

The organic EL element 7 is formed by sequentially stacking an anode 155 made of a transparent electrode such as indium tin oxide (ITO), a hole transport layer 156, a luminescence layer 157, an electron transport layer 158 and a cathode 159 made of metal such as aluminum. Holes injected from the anode 155 to the hole transport layer 156 and an electron injected from the cathode 159 to the electron transport layer 158 are recombined with each other in the luminescence layer 157, thus emitting light. As shown with an arrow in Fig. 15B, the light is emitted from the transparent anode 155 side through the glass substrate 151 to the outside. The anode 155 and the luminescence layer 157 are individually formed for each pixel, and the hole transport layer 156, the electron transport layer 158 and the cathode 159 are formed in common to each pixel. This technology is described for instance in Japanese Patent Application Publication No. 2002-251167.

The unevenness of brightness, that is, varied luminescence brightness in each pixel, occurs in an LCD, an organic EL display device, or the like, which have many pixels. Especially, as described above, it is problematic that there are many cases where the unevenness of brightness becomes remarkable among the organic EL elements, which are current-driven type light emitting elements to emit light depending on a current flowing between the anode and the cathode.

Moreover, although there is a brightness half-life for the organic EL element, this period too is not uniform for each pixel 130. Therefore, when there is a pixel whose brightness falls extremely compared with the surrounding pixels, even if there is no problem with the other pixels 130, after all the organic EL display device cannot offer the sufficient characteristics. Thus, there has been a problem that the lifetime of the organic EL display device can not be extended.

It is thus an object of this invention to provide an improved organic EL display device.

### SUMMARY OF THE INVENTION

The solution according to the invention lies in the features of the independent claims and preferably in those of the dependent claims.

The invention provides an organic electroluminescent display device that includes a plurality of drain lines and a plurality of gate lines disposed in a matrix form on a substrate, and a plurality of light emitting pixels disposed on the substrate in accordance with the matrix form of the drain lines and the gate lines. Each of the light emitting pixels comprises a drive transistor, a selection transistor and an organic electroluminescent element. The display device also includes a plurality of photosensors disposed on the substrate and each provided for corresponding light emitting pixels to measure brightness of corresponding organic electroluminescent elements.

As an alternative, a photosensor is disposed in each of the light emitting pixels and comprises a photosensor transistor. The gate of the photosensor transistor receives a constant voltage, the source or the drain of the photosensor transistor is connected with a power supply terminal of the drive transistor, and the source or the drain of the photosensor transistor that is not connected with the power supply terminal is connected with a control terminal of the drive transistor.

As another alternative, a photosensor is disposed in each of the light emitting pixels and measures brightness of a corresponding organic electroluminescent element. The photosensor is configured to change a photosensitivity thereof.

According to the invention the following advantages can be achieved. First, a photosensor is provided in a light emitting pixel of an organic EL display device, thus detecting the light emitting amount of an organic EL element. Accordingly, it is possible to correct the brightness of the organic EL element. Therefore, the brightness is corrected depending on the light emitting amount of each pixel, thus making it possible to prevent the unevenness of brightness in a display unit from occurring.

Second, the amount of current of a drive transistor to be connected to the organic EL element is adjusted depending on the light emitting amount of the organic EL element, thus reducing the amount of current to be supplied to the organic EL element depending on the light emitting amount. Consequently, it is possible to prevent the unevenness of brightness from occurring since the luminescence brightnesses draw close to the lowest one. In addition, this adjustment brings the luminescence brightnesses of the pixels close to the lowest one among them. Therefore, this can contribute to lower power consumption and a longer lifetime.

Third, since the photosensor includes one thin film transistor, the correction of brightness can be performed for each pixel with its small footprint.

Fourth, the photosensor includes a photoreceptor circuit at least having a plurality of thin film transistors, and can adjust the photoreception sensitivity for each photoreceptor circuit. Therefore, since the photoreception sensitivity can be made substantially uniform among the plurality of pixels, the brightness can be averaged among each pixel.

Fifth, since the brightness can be corrected by adjusting a reference voltage of a data signal to be supplied to a drain line depending on the light emitting amount, it is possible to contribute to lower power consumption. Moreover, since a brightness half-life can be extended due to an adjustment of the reference voltage, it is possible to extend the lifetime of the organic EL display device.

Sixth, since the power supply and input signal of the photoreceptor circuit are supplied from a gate line, a first power supply line and a second power supply line, it is possible to use those lines for the power and input signal of a light emitting pixel in common with the photoreceptor circuit. That is, it is possible to avoid making wiring complex even if with a configuration of disposing the photoreceptor circuit for each pixel. In addition, since it is possible to adjust the photoreception sensitivity by use of a resistance value of a resistor composing the photoreceptor circuit, the photoreception sensitivity can be made substantially uniform among the plurality of pixels.

Seventh, a transistor for detecting the light emitting amount has a LDD structure. Thus, it is possible to promote the generation of a photocurrent. Especially, the LDD structure adopted on the output side of the photocurrent will be effective to promote generation of photocurrent. In addition, by adopting the LDD structure, the off characteristics (the detection region) of Vg-Id characteristics is stabilized, and a stable device can be obtained.

### BRIEF DESCRIPTION OF THE DRAWINGS

Fig. 1 is a schematic diagram showing an organic EL display device of a first embodiment of the present invention.
Fig. 2 is a cross-sectional view explaining a light emitting pixel of the first embodiment of the present invention.
Fig. 3 is a circuit diagram explaining the light emitting pixel of the first embodiment of the present invention.
Fig. 4A is a plan view explaining a photosensor of the first embodiment of the present invention.
Fig. 4B is a cross-sectional view explaining the photosensor of the first embodiment of the present invention.
Fig. 5 is a schematic diagram showing an organic EL display device of a second embodiment of the present invention.
Fig. 6A is a circuit diagram explaining a light emitting pixel of the second embodiment of the present invention.
Fig. 6B is a plan view of a photosensor explaining the light emitting pixel of the second embodiment of the present invention.
Fig. 7 is a circuit diagram explaining the photosensor of the second embodiment of the present invention.
Figs. 8A to 8B are characteristics diagrams explaining the photosensor of the second embodiment of the present invention.
Figs. 9A to 9C are characteristics diagrams explaining the photosensor of the second embodiment of the present invention.
Figs. 10A to 10C are circuit diagrams explaining the photosensor of the second embodiment of the present invention.
Figs. 11A to 11D are circuit diagrams explaining the photosensor of the second embodiment of the present invention.
Fig. 12A is a block diagram explaining the organic EL display device of the second embodiment of the present invention.
Fig. 12B is a characteristics diagram explaining the organic EL display device of the second embodiment of the present invention.
Fig. 13A is a block diagram explaining the organic EL display device of the second embodiment of the present invention.
Fig. 13B is a circuit diagram explaining the organic EL display device of the second embodiment of the present invention.
Figs. 14A to 14B are characteristics diagrams explaining the organic EL display device of the second embodiment of the present invention.
Fig. 15A is a circuit schematic diagram explaining a conventional organic EL display device.
Fig. 15B is a cross-sectional view explaining the conventional organic EL display device.

### DETAILED DESCRIPTION OF THE PREFERRED EMBODIMENTS

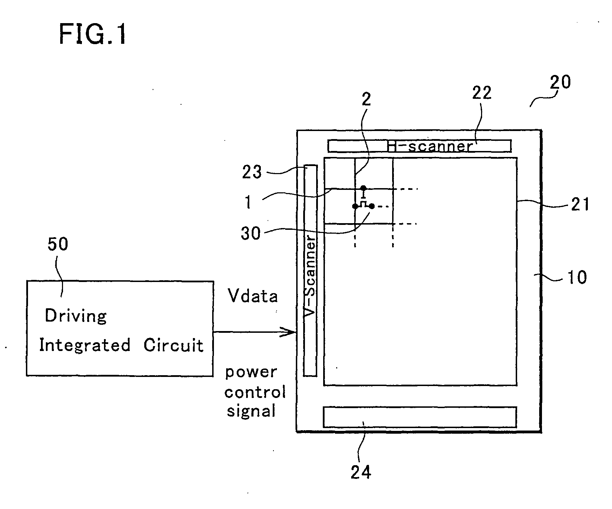

Embodiments of the present invention will be described in detail with reference to Figs. 1 to 14B, taking an active matrix type organic EL display device as an example.

First, a first embodiment of the present invention will be shown in Figs. 1 to 4B.

Fig. 1 is a schematic view showing an organic EL display device. An organic EL display device 20 includes a substrate 10, drain lines 2, gate lines 1, a display unit 21, a horizontal scanning circuit 22, a vertical scanning circuit 23 and photosensors.

Furthermore, the organic EL display device 20 includes a driving integrated circuit 50. The driving integrated circuit 50 controls the display device by, for example, outputting a data signal Vdata and applying a drive voltage to a transistor which is connected to an organic EL element of the display unit 21 in order to cause the organic EL element to emit light.

The display unit 21 is formed in a manner that a plurality of light emitting pixels 30 are disposed in a matrix form on the insulating substrate 10 made of a glass plate or the like. The light emitting pixel 30 includes an EL element having a luminescence layer between an anode and a cathode, a driver transistor of the EL element and a selection transistor. Both of the driver transistor and the selection transistor are thin film transistors (hereinafter referred to as TFTs).

On sides of the display unit 21, the horizontal scanning circuit (hereinafter referred to as the H scanner) 22, which sequentially selects the drain lines 2, is disposed on one side thereof, and a vertical scanning circuit (hereinafter referred to as the V scanner) 23, which sends gate signals to the gate lines 1, is disposed on another side thereof. Further, unillustrated lines which transmit various signals inputted to the gate lines 1, the drain lines 2 and the like are gathered to a side of the substrate 10, and are connected to an external connector 24.

The photosensors (not shown here) are the TFTs provided respectively in each of the light emitting pixels 30. Photocurrents can be obtained by use of light emitted when the TFTs are off. The photosensor in this embodiment performs the correction of brightness for the organic EL element by detecting the light emitting amount of the relevant organic EL element which composes the light emitting pixel 30.

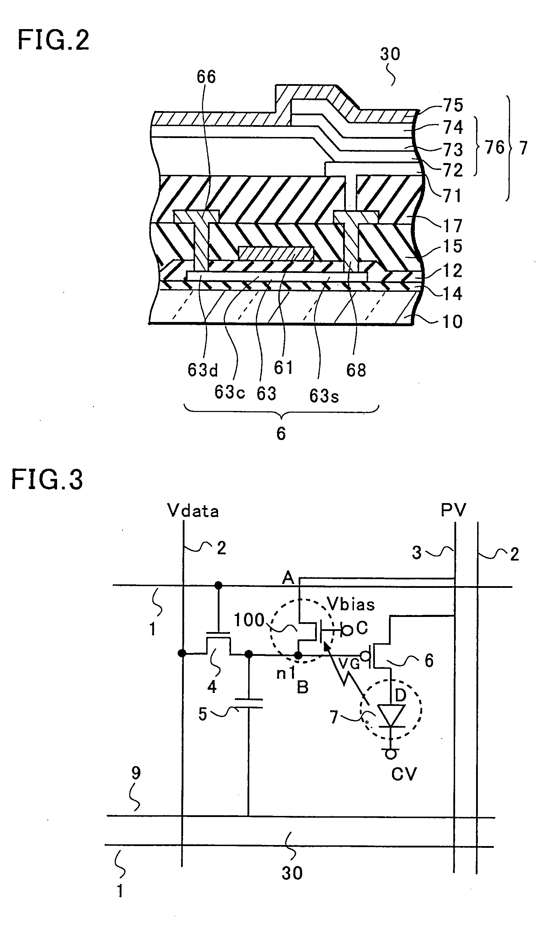

Fig. 2 is a cross-sectional view of a part of the light emitting pixel 30, and shows a part of a drive TFT 6 and of an organic EL element 7.

An insulation film (made of SiN, SiO₂ or the like) 14, which serves as a buffer layer, is provided on the insulating substrate 10 made of silica glass, no-alkali glass or the like, and thereon a semiconductor layer 63 made of a p-Si(poly-silicon) film is laminated. This p-Si film may be formed by laminating an amorphous silicon film, and recrystallizing the film by laser annealing or the like.

On the semiconductor layer 63, a gate insulation film 12 made of SiN, SiO₂ or the like is laminated, and thereon a gate electrode 61 made of refractory metal, such as chrome (Cr), molybdenum (Mo) or the like, is formed. In the semiconductor layer 63, an intrinsic or substantially intrinsic channel 63c which is located below the gate electrode 61 is provided. In addition, the drive TFT 6 is composed by providing a source 63s and a drain 63d, which are n⁺ impurity diffusion regions on both sides of the channel 63c. Note that although the illustration is omitted, the selection TFT has a similar structure to that of the drive TFT 6.

All over the gate insulation film 12 and the gate electrode 61, a SiO₂ film, a SiN film, and a SiO₂ film, for example, are sequentially laminated to form an interlayer insulation film 15. In the gate insulation film 12 and the interlayer insulation film 15, contact holes are provided, corresponding to the drain 63d and the source 63s. The contact holes are filled with metal, such as aluminum (Al) or the like, to provide a drain electrode 66 and a source electrode 68, which are brought into contact with the drain 63d and the source 63s, respectively. On a planarizing insulation film 17, an anode 71 is provided to serve as a display electrode such as indium tin oxide (ITO). The anode 71 is connected to the source electrode 68 (or the drain electrode 66) by use of contact holes provided in the planarizing insulation film 17.

The organic EL element 7 is formed by providing an organic EL layer 76 on the anode 71 and further forming a cathode 75 made of an alloy of magnesium and indium. The organic EL layer 76 is formed by sequentially stacking a hole transport layer 72, a luminescence layer 73 and an electron transport layer 74. This cathode 75 is provided all over the substrate 10 or all over the display unit 21 to form the organic EL display device 20 shown in Fig. 1.

In addition, in the organic El element 7, holes injected from the anode 71 and electrons injected from the cathode 75 are recombined inside the luminescence layer 73, thus exciting organic molecules which form the luminescence layer 73. For this reason, an exciton occurs. In course of radiative deactivation of this exciton, light is emitted from the luminescence layer 73. This light is then released from the transparent anode 71 through the transparent insulating substrate 10 to the outside. Thus, the organic EL element 7 emits light. Note that a bottom emission structure to emit light toward the substrate 10 is employed in this embodiment as an example.

Fig. 3 shows a circuit diagram of one pixel out of the light emitting pixels 30 of the display unit 21.

On the substrate, the plurality of gate lines 1 extending in the row direction are disposed. The plurality of drain lines 2 and first power supply lines 3 extending in the column direction are disposed to intersect the gate lines 1. The first power supply lines 3 are connected to a power source PV. The power source PV is a power source to output a positive constant voltage, for example.

Each intersection of the gate lines 1 and the drain lines 2 is connected to a selection TFT 4. The gate of the selection TFT 4 is connected to the gate line 1, and the drain of the selection TFT 4 is connected to the drain line 2. The source of the selection TFT 4 is connected to a hold capacitor 5 and a gate of the drive TFT 6.

A drain of the drive TFT 6 is connected to the first power supply line 3, and a source of the drive TFT 6 is connected to the anode of the organic EL element 7. The cathode of the organic EL element 7 is connected to a power source CV. The power source CV is a power source to output a negative constant voltage. A second power supply line 9 extending in the column direction is connected to the counter electrode of the hold capacitor 5. The second power supply line 9 is a power supply line to have a lower voltage than the first power supply line 3. Note that although the hold capacitor 5 is connected to the second power supply line 9 in Fig. 3, a specialized capacity line (unillustrated) may be provided to be connected to the hold capacitor 5.

The gate signals are sequentially applied to the gate lines 1 by use of the V scanner (unillustrated). The gate signals are binary signals of on or off. When the signals are on, the gate signals are at a positive predetermined voltage; when off, the gate signals are 0 V. The V scanner turns on the gate signals of a selected predetermined gate line 1 out of the plurality of gate lines 1 connected to the V scanner. When the gate signals are on, all the selection TFTs 4 connected to the selected predetermined gate line 1 are turned on. Then, the drain lines 2 and the gates of the drive TFTs 6 are connected through the selection TFTs 4.

Data signals Vdata determined depending on an image to be displayed are outputted from the H scanner (unillustrated) to the drain lines 2. The data signals Vdata are inputted to the gates of the drive TFTs 6 and are charged in the hold capacitors 5.

The hold capacitor 5 has a capacitance between other electrodes such as the second power supply line 9 or the first power supply line 3, and can store the data signals for a certain period of time.

Even after the V scanner selects another gate line 1, the previously selected gate line 1 becomes unselected, and the selection TFT 4 is turned off, the data signals are held by the hold capacitors 5 during one vertical scanning period. In the meantime, the drive TFT 6 holds conductivity depend on the magnitude of the data signals, thus enabling the organic EL elements 7 to continue to emit light with a brightness in response to the data signals.

The drive TFT 6 and the organic EL element 7 are connected in series between the positive power source PV and the negative power source CV. In other words, the drive TFT 6 connects the first power supply line 3 to the organic EL element 7 with conductivity depending on the magnitude of the data signals Vdata. Drive currents flowing to the organic EL element 7 are supplied from the power source PV through the drive TFT 6 to the organic EL element 7, and the organic EL element 7 emits light with a brightness in response to the data signals Vdata. Thus, the drive currents can be controlled by changing a gate voltage VG of the drive TFT 6. As described above, the data signals Vdata are inputted to the gate electrode, and the gate voltage VG is set to be a value in response to the data signals Vdata.

In this embodiment, a photosensor 100 is connected to inside each of the light emitting pixel 30 shown in Fig. 3. One terminal of the photosensor 100 is connected to the first power supply line 3 which connects to the power source PV, and the other terminal is connected to the control terminal (the gate electrode) of the drive TFT 6. Then, a constant voltage Vbias to be a reverse bias voltage is applied to the control terminal (the gate electrode) of the photosensor 100.

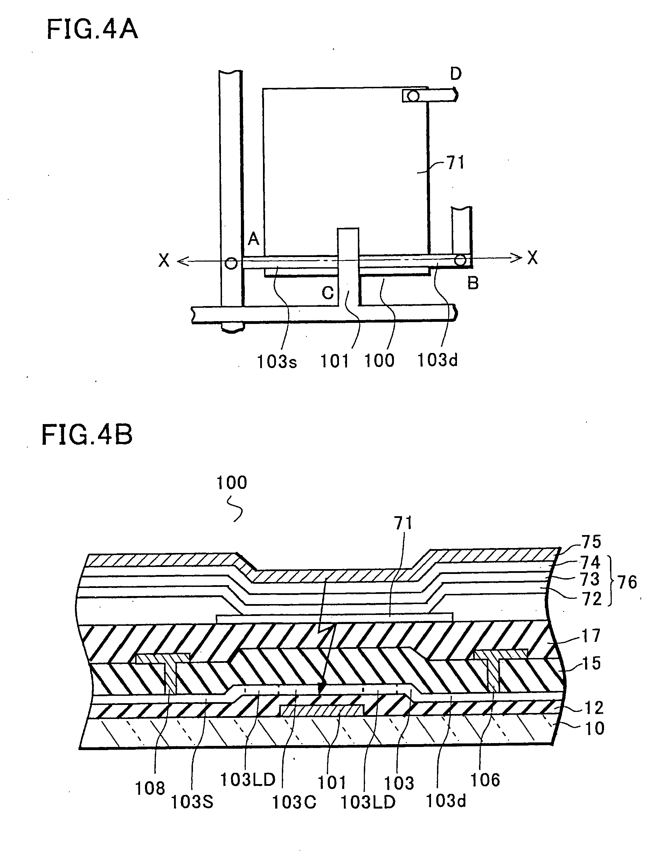

Figs. 4A and 4B are explanatory views of the structure of the photosensor 100. Fig. 4A is a plan view showing the vicinity of a circled area in Fig. 3, and terminals A, B, C and D corresponding to terminals A, B, C and D in the circuit diagram of Fig. 3 are shown. Further, Fig. 4B is a cross-sectional view taken along the X-X line in Fig. 4A. Incidentally, Fig. 4A is a plan view of when viewed from the substrate 10 side.

The photosensor is substantially the same as the drive TFT 6 of the light emitting pixel 30 as shown in Fig. 2. Therefore, the descriptions of the repeated parts will be omitted.

Specifically, the photosensor 100 is a TFT in which a gate electrode 101, the insulation film 12 and a semiconductor layer 103 made of p-Si film are stacked on the insulating substrate 10, the semiconductor layer 103 having a channel 103c, a source 103s and a drain 103d therein (see Fig. 4B).

In a p-Si TFT having a structure of this kind, when the TFT is off, if the external light enters the semiconductor layer 103, electron-hole pairs are generated in a junction region between the channel 103c and the source 103s or between the channel 103c and the drain 103d. These electron-hole pairs are separated due to the electric field in the junction region, thus generating photovoltaic force. Accordingly, the photocurrent is obtained, which is outputted from a source electrode 108 side, for example. That is, this photocurrent is a dark current of when the TFT is off. By detecting the increase of the dark current, a p-Si TFT with the above structure is used as a photosensor.

Here, the semiconductor layer 103 may be provided with a low concentration impurity region. The low concentration impurity region means a region which is provided adjacent to the source 103s or the drain 103d on the channel 103c side, and which is lower in impurity concentration compared to the source 103s or the drain 103d. By providing this region, it is made possible to relax the electric field concentrated at the edge of the source 103s (or the drain 103d). The width of the low concentration impurity region is approximately 0.5 µm to 3 µm, for example.

In this embodiment, a low concentration impurity region 103LD is provided, for example, between the channel 103c and the source 103s (or between the channel 103c and the drain 103d) to form a so-called light doped drain (LDD) structure. With the LDD structure, it is possible to increase, in the direction of a gate length L, the junction region contributing to photocurrent generation, so that photocurrent generation occurs more readily. That is, it is advantageous that the low concentration impurity region 103LD is provided at least on the drain side in terms of the photocurrent. In addition, by adopting the LDD structure, the off characteristics (the detection region) of Vg-Id characteristics is stabilized, and a stable device can be obtained.

The photosensor 100 of this embodiment senses light to be emitted by the organic EL element 7. Therefore, the organic EL layer 76 and cathode 75 of the organic EL element 7 extend to cover the photosensor 100. Due to this structure, light from the organic EL element 7 goes into the semiconductor layer 103 of the photosensor 100. The photocurrent is thus outputted depending on the amount of light emission from the source region 103s side.

Again, with reference to Fig. 3, a description will be given of the operation of this circuit. Incidentally, voltage values within parentheses are examples.

The drive TFT 6 and the organic EL element 7 are connected in series between the power source PV (6 V) and the power source CV (-6 V). The photosensor 100 is an n-channel type TFT and is applied with a reverse bias voltage Vbias (-2 V) lower than the minimum voltage (0 V) of the data signal Vdata.

The data signals Vdata (0 to 5 V) at a lower voltage than the power source PV (6 V) are inputted to the drain lines 2. For example, if the data signals Vdata at 3 V are inputted, the voltage of a connection point n1 is 3 V. If the organic EL element 7 emits light with the photosensor 100 in an off state, the light is incident into the photosensor 100, thus generating a photocurrent depending on the amount of light emission of the organic EL element 7. As described above, a photocurrent is a dark current (leak current) of when the TFT is off. That is, the potential of the connection point n1 increases depending on the amount of light emission of the organic EL element 7 as well as the potential of the power source PV. The potential of the connection point n1 is applied to the gate electrode of the drive TFT 6. Therefore, when the potential of the connection point n1 increases depending on the amount of light emission of the organic EL element 7, a voltage Vgs between the gate and source of the drive TFT 6 decreases. For this reason, a current to be supplied to the organic EL element 7 decreases, thus reducing the brightness of the corresponding light emitting pixel 30.

In this manner, the Vgs of the drive TFT 6 changes depending on the amount of light emission of the organic EL element 7 in the first embodiment. In addition, in the case of the large amount of light emission, the amount of the leak current rises in the photosensor 100, the Vgs of the drive TFT 6 falls, and the amount of light emission of the organic EL element 7 decreases.

Specifically, it is possible to reduce the amount of light emission of the organic EL element 7 depending on the degree of brightness by providing the same data signal Vdata, thus bringing the brightness as a whole close to a brightness of a pixel with a low brightness. Accordingly, it is possible to correct the unevenness of brightness so as to reduce power consumption.

Moreover, one TFT to be the photosensor 100 is sufficient to be disposed in the pixel 30. As described above, this TFT can be manufactured by use of the same process as those of the drive TFT 6 and the selection TFT 4, which compose the pixel 30. Therefore, the footprints of the TFTs can be made small in the pixel 30, and also the unevenness of brightness among each of the pixel 30 can be adjusted without making the manufacturing process complex.

Note that the photosensor 100 of this embodiment is to sense not external light but the amount of light emission from the organic EL element 7. Hence, it is desired for the photosensor 100 to have a bottom gate structure, where the gate electrode 101 is disposed below the semiconductor layer 103, to enable the light from the organic EL layer 76 to be incident directly into the semiconductor layer 103 (see Fig. 4B).

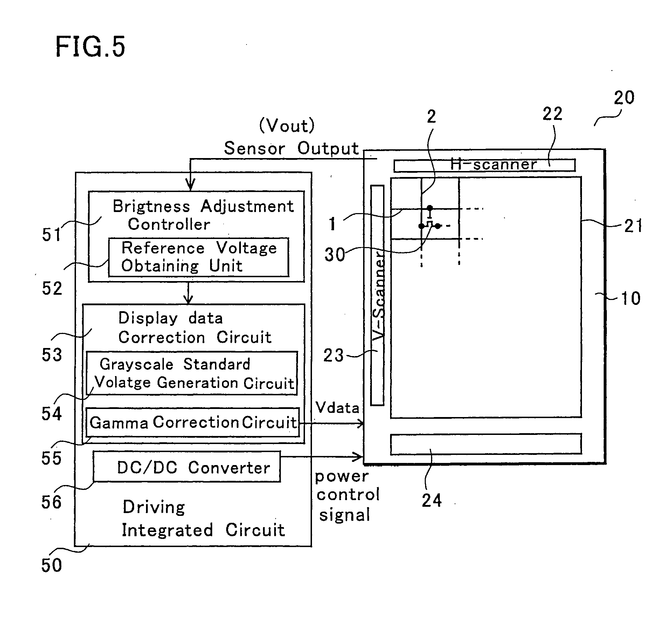

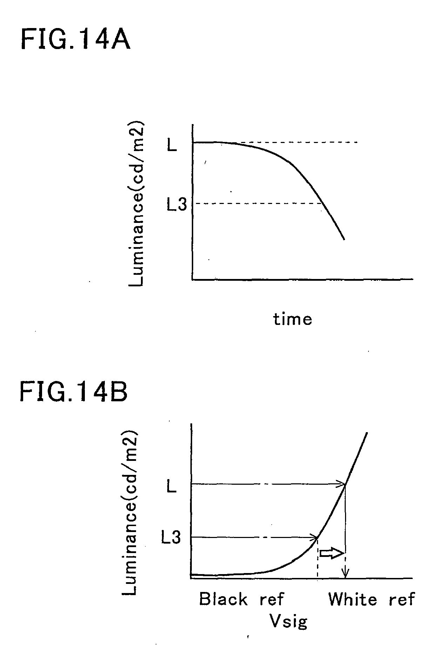

Next, with reference to Figs. 5 to 14B, a description will be given of a second embodiment of the present invention. The second embodiment is a case where a photosensor 200 is provided, the photosensor 200 having a photoreceptor circuit capable of adjusting the sensitivity of detection for each pixel.

Fig. 5 is a schematic view showing an organic EL display device 20. Note that since a display unit 21 is the same as the one in the first embodiment, the explanation thereof will be omitted.

The driving integrated circuit 50 includes a brightness adjustment controller 51 to adjust brightness and a display data correction circuit 53 to output a data signal Vdata to the display unit 21. Furthermore, the driving integrated circuit 50 includes a DC/DC converter 56, and a drive voltage is applied to a drive TFT which is connected to an organic EL element, thus causing the organic EL element to emit light.

The brightness adjustment controller 51 makes an adjustment for all the light emitting pixels 30 to average the unevenness of brightness based on the output of photosensors (not shown here). Since the photosensor has an analog output and a digital output for external light, the relation of a photocurrent to external light can be obtained by measuring the characteristics of the photosensor beforehand.

Although the details will be described later, a correction value to change the brightness of each of the pixel 30 to a standard brightness is obtained by obtaining a brightness to be a standard for averaging the brightness (hereinafter referred to as the standard brightness L) in a reference voltage obtaining unit 52. The correction value is used as a data signal Vdata at the display data correction circuit 53.

The display data correction circuit 53 includes: a grayscale standard voltage generation circuit 54 for obtaining a plurality of grayscale display voltages by separating voltages between a first reference voltage and a second reference voltage; and a gamma correction circuit 55. A gamma correction is to correct a relation that output brightness is in proportion to the gamma power of an input signal into a relation that output brightness is in proportion to an input signal.

The first reference voltage to be a low potential is in the maximum level of brightness (white) of the EL element, and the second reference voltage to be a high potential is in the minimum level of brightness (black) of the EL element. Hereinafter in this specification, the first reference voltage is referred to as the white reference voltage and the second reference voltage as the black reference voltage.

The correction value is inputted to the display data correction circuit 53. The correction value is used as the white reference voltage of the grayscale standard voltage generation circuit 54. The grayscale standard voltage generation circuit 54 divides voltages for each color of R, G and B between the white reference voltage and the black reference voltage to generate a plurality of grayscale display voltages. The display data correction circuit 53 performs a digital to analog (D/A) conversion on a data signal. Then, the analog data signals of R, G and B are generated by use of the plurality of grayscale display voltages, which are further corrected at the gamma correction circuit 55. The corrected signals are then outputted to the display unit 21 as the data signals Vdata to display an image. As a consequent, the display unit 21 displays a grayscale image based on the grayscale display voltages.

Specifically, in this embodiment, a correction value is obtained to change the brightness of each of the light emitting pixel 30 into the standard brightness L, and the obtained correction value is used as the white reference voltage of the grayscale standard voltage generation circuit 54.

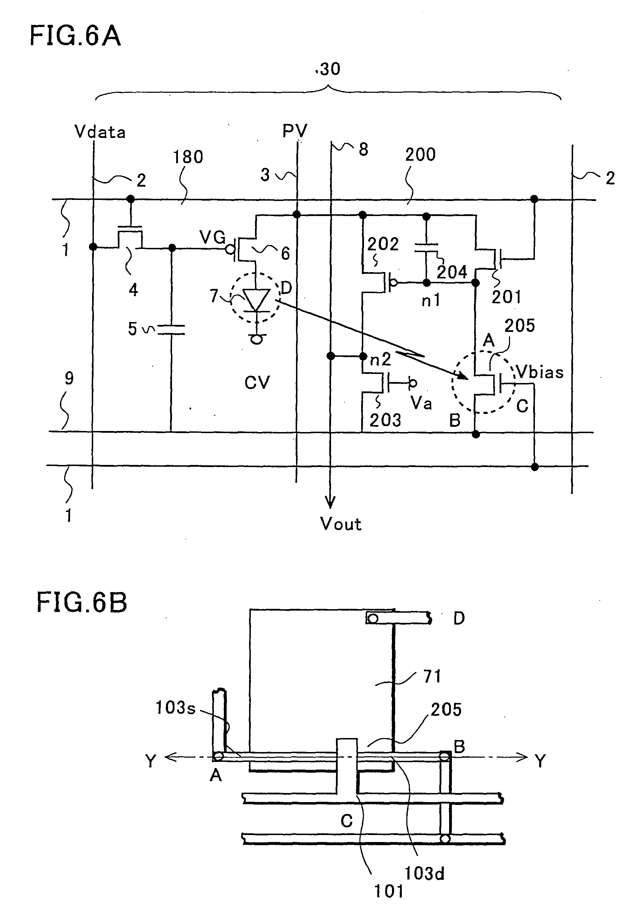

Figs. 6A and 6B show one pixel in the second embodiment. Fig. 6A is a circuit diagram. Fig. 6B is a plan view of a circled area shown in Fig. 6A, and terminals A, B, C and D corresponding to those in the circuit diagram of Fig. 6A is shown in Fig. 6B. A cross-sectional view taken along the Y-Y line in Fig. 6B is the same as the one in Fig. 4B. A description thereof will be thus omitted. Fig. 6B is a plan view of when viewed from a substrate 10 side.

The light emitting pixel 30 is configured to connect a photoreceptor circuit 200, which becomes a photosensor, to a light emitting circuit 180. On the substrate, a plurality of gate lines 1 extending in the row direction are disposed. A plurality of drain lines 2 and first power supply lines 3 extending in the column direction are disposed to intersect the gate lines 1. The first power supply lines 3 are connected to a power source PV. The power source PV is a power source to output a positive constant voltage, for example.

The light emitting circuit 180 includes a selection TFT 4, a hold capacitor 5, a drive TFT 6 and an organic EL element 7, which are connected to each intersection of the gate lines 1 and the drain lines 2. A gate of the selection TFT 4 is connected to the gate line 1, and a drain of the selection TFT 4 is connected to the drain line 2. A source of the selection TFT 4 is connected to the hold capacitor 5 and a gate of the drive TFT 6.

A drain of the drive TFT 6 is connected to the first power supply line 3, and a source of the drive TFT 6 is connected to an anode of the organic EL element 7. A cathode of the organic EL element 7 is connected to a power source CV. The power source CV is a power source to output a negative constant voltage. A second power supply line 9 extending in the column direction is connected to the counter electrode of the hold capacitor 5.

The first power supply line 3 is connected to the power source PV. That is, the drive TFT 6 is connected to the first power supply line 3 and the organic EL element 7 with conductivity depending on the magnitude of the data signals Vdata. As a result, a current in response to the data signals Vdata is supplied from the first power supply line 3 through the drive TFT 6 to the organic EL element 7. Accordingly, the organic EL element 7 emits light with a brightness in response to the data signal Vdata.

The hold capacitor 5 has a capacitance between other electrodes such as the second power supply line 9 or the first power supply line 3, and can store the data signals for a certain period of time.

Even after a V scanner selects another gate line 1, the previously selected gate line 1 becomes unselected and the selection TFT 4 is turned off, the data signals Vdata are held by the hold capacitor 5 during one vertical scanning period. In the meantime, the drive TFT 6 holds the conductivity, thus enabling the organic EL element 7 to continue to emit light with the brightness.

The drive TFT 6 and the organic EL element 7 are connected in series between the positive power source PV and the negative power source CV. A drive current flowing to the organic EL element 7 is supplied from the power source PV through the drive TFT 6 to the organic EL element 7, and the drive current can be controlled by changing a gate voltage VG of the drive TFT 6. As described above, the data signals Vdata are inputted to the gate electrode, and the gate voltage VG thus has a value corresponding to the data signal Vdata.

The photoreceptor circuit 200 to be the photosensor is connected to the gate lines 1, the power supply line 3, the second power supply line 9 and a sensor output line 8 of the light emitting circuit 180 in each of the light emitting pixel 30. The sensor output line 8 is connected to one terminal of a resistor 203 of the photoreceptor circuit 200, thus outputting a detection result Vout of the photoreceptor circuit (photosensor) 200 to the driving integrated circuit 50. Note that the potential of the second power supply line 9 is lower than that of the first power supply line 3. In addition, the hold capacitor 5 is connected to the second power supply line 9, but a specialized capacity line (unillustrated) may be provided to be connected to the hold capacitor 5.

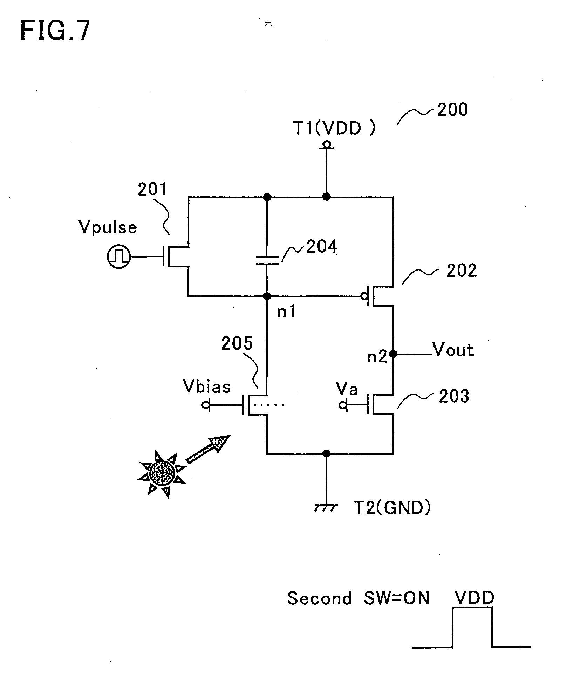

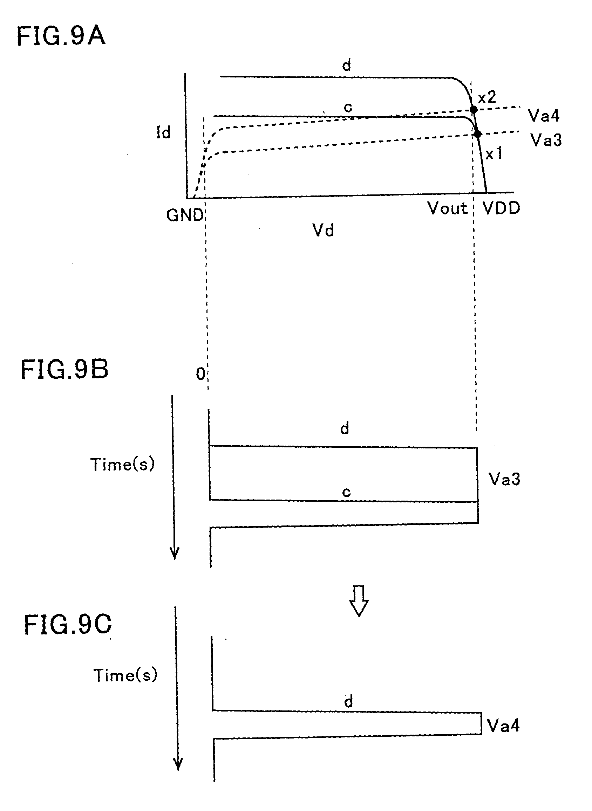

With reference to Figs. 7 to 9C, a description will be given of the photosensor 200 of the second embodiment.

Fig. 7 is a circuit diagram showing a taken out part which is a photoreceptor circuit to be the photosensor 200. The photosensor 200 includes a phototransistor 205, a capacitor 204, a first switching transistor 201, a second switching transistor 202, a first connection point n1, a second connection point n2, a resistor 203, a first power supply terminal T1 and a second power supply terminal T2.

It is sufficient if the first power supply terminal T1 has a higher voltage than the second power supply terminal T2. Here, a description will be given, assuming that the first power supply terminal T1 is a VDD potential and the second power supply terminal T2 is a GND potential as an example.

The first switching transistor 201 is brought into conduction by use of an input of an input signal (voltage) Vpulse to a control terminal thereof. The first switching transistor 201 is connected in series to the phototransistor 205. Both are connected between the first power supply terminal T1 and the second power supply terminal T2.

Further, the second switching transistor 202 and the resistor 203 are connected in series. These are also connected between the first power supply terminal T1 and the second power supply terminal T2.

One terminal of the capacitor 204 is connected to a control terminal of the second switching transistor 202 by use of the first connection point n1, and the other terminal is connected to the first power supply terminal T1 or the second power supply terminal T2. The capacitor 204 is charged by bringing the first switching transistor 201 into conduction. The potential of the first connection point n1 is thus changed.

Hereinafter, a description will be given in detail. The one terminal of the capacitor 204 is connected to an output terminal of the phototransistor 205 by use of the first connection point n1, and the other terminal is connected to the first power supply terminal T1. The first switching transistor 201 is connected in parallel to the capacitor 204. Pulses are inputted to the control terminal of the first switching transistor 201 for a certain period of time.

The second switching transistor 202 is connected in series between the first power supply terminal T1 and the second power supply terminal T2. The output from the first connection point n1 is applied to the control terminal of the second switching transistor 202. As an example, the first switching transistor 201 is an n-channel type TFT, and the second switching transistor 202 is a p-channel type TFT. Their structures are the same as that of the drive TFT 6 in Fig. 2.

One terminal of the resistor 203 is connected to one terminal of the second switching transistor 202 by use of the second connection point n2, and the other terminal is connected to the second power supply terminal T2 and is grounded. The resistor 203 is, for example, a p-channel type TFT, and a control terminal thereof is applied with a constant voltage Va. If the gate voltage Va is fixed in a manner that a resistance between a source and drain of the TFT is high, it is possible to use the TFT as a resistance. Consequently, a photocurrent sensed at the phototransistor 205 is converted into a voltage, which is then outputted from the second connection point n2. The voltage outputted due to a change in the constant voltage Va is changed, too. Note that a resistance value between the source and the drain of the resistor(TFT) 203 is approximately 10³ Ω to 10⁸ Ω in this case.

In this manner, by connecting the resistor 203 having a high resistance value between the first power supply terminal T1 and the second power supply terminal T2, the photocurrent sensed at the phototransistor 205 can be outputted as a divided voltage of a potential difference between a power supply potential VDD and a ground potential GND. A voltage between the first power supply terminal T1 and the second power supply terminal T2 may be set within a range where its use as a feedback is easy. Incidentally, a change of the constant voltage Va and a detail description of the circuit operation will be given later. And the phototransistor 205 has the same structure as the photosensor that shown in Fig.4B, thus the description will be omitted.

Note that, in this embodiment, it is suitable to relax the electric field concentrated at the end of a source (or a drain) if the first and second switching transistors 201 and 202 also have a so-called LDD structure.

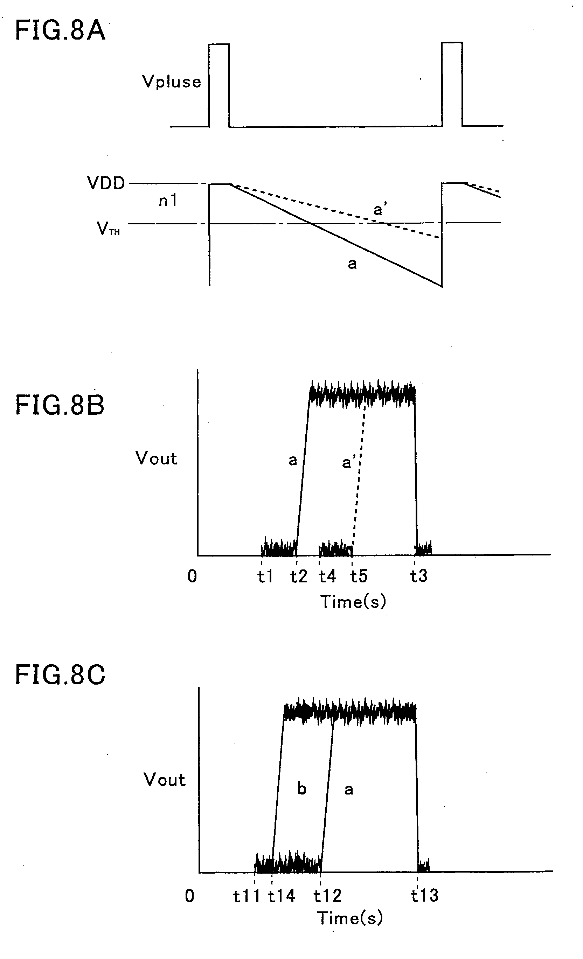

With reference to Figs. 7 to 8C, a description will be given of the operation of the photosensor 200. Fig. 8A is a timing chart and Figs. 8B and 8C are the examples of the output voltages Vout.

Pulses of a predetermined voltage Vpulse (H level) are inputted to the control terminal, that is, the gate electrode, of the first switching transistor 201 for a certain period of time. While the H level pulses are being inputted, the conduction of the first switching transistor 201 is maintained. Accordingly, the capacitor 204 is charged with electric charges of the power supply potential VDD.

When the pulses fall to L level (0 V), the first switching transistor 201 is cut off. In this embodiment, the standard potential (VDD potential) is set to be the potential of the first connection point n1, and the output voltage is obtained by causing the potential of the first connection point n1 to decrease due to the discharge from the phototransistor 205.

When the phototransistor 205 is irradiated with light, a very small photocurrent of, for example, approximately 10⁻¹⁴ A to 10⁻⁹ A is outputted. As described above, the photocurrent is a dark current to be generated depending on light quantity irradiated when a TFT, which composes the phototransistor 205, is off. In other words, a current leaking from the phototransistor 205 due to light is sensed, thus detecting the light quantity. Therefore, if the phototransistor 205 is irradiated with light, electric charges are discharged from the phototransistor 205 depending on the light quantity, and the standard potential (VDD potential) of the first connection point n1 falls as shown in Fig. 8A with a solid line a.

The second switching transistor 202 is a p-channel type TFT, and a control terminal (gate electrode) thereof is connected to the first connection point n1. That is, if the potential of the first connection point n1 decreases to the threshold voltage VTH or under, the second switching transistor 202 is brought into conduction.

The resistor 203 is in conduction by use of the constant voltage Va, and a channel is formed depending on the constant voltage Va. Thus, it can be considered to be a resistor with a constant resistance value. The output voltage Vout is outputted by dividing the potential difference between the first power supply terminal T1 and the second power supply terminal T2 with the resistance values of the second switching transistor 202 and the resistor 203. In other words, before the second switching transistor 202 is brought into conduction, the resistance value of the second switching transistor 202 is sufficiently larger than that of the resistor 203, and the potential of the second connection point n2 thus draws closer to that of the second power supply terminal T2. To the contrary, after the second switching transistor 202 is brought into conduction, the resistance value of the second switching transistor 202 becomes sufficiently smaller than that of the resistor 203, and the potential of the second connection point n2 thus draws closer to that of the first power supply terminal T1.

Specifically, the photocurrent sensed at the phototransistor 205 can be detected as the output voltage Vout whose value is close to that of the power supply potential VDD, by dividing the potential deference between the power supply potential VDD and the ground potential GND.

Here, since the resistance value of the resistor 203 is very high, it is possible to obtain the output voltage Vout whose value is reasonably large to the extent of providing a feedback easily even if the photocurrent is very small.

In this manner, the photosensor 200 can be operated by simply inputting a pulse of the voltage Vpulse to the first switching transistor 201. Moreover, the photosensor 200 can be also realized with the components of only three TFTs and one capacitor for the circuit formation. Thus, the number of parts can be reduced.

Figs. 8B and 8C show examples of outputting the output voltage Vout by use of light quantity. The x-axes in the graphs indicate time and the y-axes indicate the output voltages Vout. The solid line a and the dashed line a' show a case where the constant voltages Va of the resistor 203 are the same value, but light quantity detected at the phototransistor 205 is different. The solid lines a and b show a case where the constant voltages Va of the resistor 203 differ from each other.

The relation between the light quantity, the value of the constant voltage Va ( Va value) of the resistor 203 and the time for the output voltage Vout to be outputted becomes clear from these graphs.

First, with reference to Fig. 8B, descriptions will be given of a case (solid line a) where light quantity is larger and a case (dashed line a') where light quantity is smaller. In both cases, the Va values are the same.

As described above, the potential of the first connection point n1 increased to the standard potential VDD by use of the input signals (voltage) Vpulse decreases depending on light quantity sensed at the phototransistor 205 (solid line a in Fig. 8A). Then, the voltage decreases to under the threshold voltage of the second switching transistor 202. When the second switching transistor 202 is turned on, a current flows from the first power supply terminal T1 to the resistor (TFT) 203 (t1 in Fig. 8B). The channel is formed in the resistor 203 depending on the gate voltage Va, and the current flowing to the resistor 203 reaches saturation after a predetermined period elapsed. For this reason, the resistor 203 comes to have a constant resistance value. At that time, as a divided voltage of the power supply potential VDD and the resistor 203, the output voltage Vout can be detected at the second connection point n2 (t2 in Fig. 8B).

Further, after a certain period elapsed, if the voltage Vpulse is inputted to the first switching transistor 201, the second switching transistor 202 is turned off. Hence, the output voltage Vout is substantially 0 V (t3). In other words, the output voltage Vout can be detected in binary as a time during which the output voltage Vout is detected (H level) and a time during which the output voltage Vout is not detected (L level).

When the light quantity is small as shown with the dashed line a', the discharge amount from the phototransistor 205 becomes small. Accordingly, the time for the dashed line a' to reach the threshold voltage of the second switching transistor 202 becomes later than that for the solid line a. That is, the timing for the second switching transistor 202 to be turned on becomes later (t4), and the timing for the output voltage Vout to reach H level becomes later (t5). The second switching transistor 202 is turned off by use of Vpluse inputted to the first switching transistor 201 at certain intervals. Then, the output voltage Vout falls to L level (t3). The time until the current flowing in the resistor 203 reaches saturation is substantially constant. Therefore, the delay for the second switching transistor 202 to be turned on indicates shortening the period during which the output voltage Vout stays H level.

Moreover, the longer the period to stay at H level is, the longer the time during which the output voltage Vout can be detected is. Accordingly, this means that the sensitivity as a photosensor is excellent. Therefore, the sensitivity of the photosensor 200 can be changed depending on small or large light quantity (solid and dashed lines a and a').

Next, with reference to Fig. 8C, descriptions will be given of a case where the Va value is large (solid line a) and a case where the Va value is small (solid line b). In both cases, the light quantity is the same.

As described above, the potential of the first connection point n1 is increased to the standard potential VDD by inputting the input signals(voltages) Vpulse decreases depending on the light quantity sensed at the phototransistor 205 (solid line a in Fig. 8A). The potentioal of the first connection point n1 falls to under the threshold voltage of the second switching transistor 202, thus causing the second switching transistor 202 to be turned on. Then, the current flows from the first power supply terminal T1 to the resistor (TFT) 203 (t11 in Fig. 8C). The channel is formed in the resistor 203 depending on a larger gate voltage Val. After a certain period elapsed, the flowing current reaches saturation. For this reason, the resistor 203 comes to have a constant resistance value. At that time, as a divided voltage of the power supply potential VDD and the resistor 203, the output voltage Vout can be detected at the second connection point n2 (t12 in Fig. 8C).

After a certain period further elapsed, if the voltage Vpulse is inputted to the first switching transistor 201, the second switching transistor 202 is turned off. Hence, the output voltage Vout becomes substantially 0 V (t13). In other words, the output voltage Vout can be detected in binary as a time during which the output voltage Vout is detected (H level) and a time during which the output voltage Vout is not detected (L level).

As shown with the solid line b, when the Va value is small (Va2), if the light quantity is the same, a time to reach the threshold voltage of the second switching transistor 202 is substantially the same as that of the solid line a. Therefore, timing for the second switching transistor 202 to be turned on is the same (t11).

When the second switching transistor 202 is turned on, the current flows from the first power supply terminal T1 to the resistor (TFT) 203. The channel is formed in the resistor 203 depending on a lower gate voltage Va2. After a predetermined period elapsed, the flowing current reaches saturation. After that, the output voltage Vout can be detected by use of the divided voltage depending on the resistance value of the resistor 203 (t14).

After a certain period further elapsed, if the voltage Vpulse is inputted to the first switching transistor 201, the second switching transistor 202 is turned off. Hence, the output voltage Vout becomes substantially 0 V (t13 in Fig. 8C).

Here, if the gate voltage Va2 is low, the channel width of the TFT 203 becomes narrow, too. Hence, timing when the current flowing in the resistor 203 reaches saturation becomes earlier in the case of the gate voltage Va2 than in the case of the gate voltage Val. Accordingly, timing to detect the output voltage Vout becomes earlier, thus extending a period to stay at H level (t12 to t14).

In other words, if the Va value is small, the sensitivity of the photosensor 200 is improved, and also the sensitivity can be adjusted by a change in Va value.

With reference to Figs. 9A to 9C, descriptions will be further given. Fig. 9A shows an example of the gate voltage Va of the resistor 203 and the Vd-Id characteristics of the second switching transistor 202. Solid lines c and d indicate the Vd-Id characteristics of the second switching transistor 202. The solid line c indicates a state to have a large light quantity while the solid line d indicates a state to have a small light quantity. In addition, dotted lines Va3 and Va4 indicate the Vd-Id characteristics of the resistor (TFT) 203. The dotted line Va3 indicates a state to have a small gate voltage, and the dotted line Va4 indicates a state to have a large gate voltage. Moreover, Fig. 9B is a schematic diagram where the x-axis and y-axis of the output example of Fig. 8C are interchanged to correspond to Fig. 9A.

As shown in Figs. 9A and 9B, in the case of the gate voltage Va3, there is an intersection of the solid lines c and d, x1, in the linear region of the second switching transistor 202(the dotted line). Both the solid lines c and d can be detected as the output voltage Vout of H level. In the case of the solid line d, the output voltage Vout has a longer detection period than the solid line c.

On the other hand, as shown in Figs. 9A and 9C, if the gate voltage Va is excessively high (Va4), there is only the solid line d at an intersection x2 in the linear region of the second switching transistor 202(the dotted line). The solid line c shows that the output voltage Vout can not be detected since a saturation state at the resistor 203 brings a saturation state at the second switching transistor 202, too. In addition, the detection period of the solid line d is shortened.

Therefore, the voltage Vpulse and the gate voltage Va are selected suitably such that the Vd-Id curves of the resistor 203 intersect in the linear region of the second switching transistor 202.

In this manner, the photosensor 200 can obtain a binary output by turning on and off the second switching transistor 202. However, the output voltage Vout can be outputted in analog by calculating the integration area. In the second embodiment, an analog output is used.

In the second embodiment, the above-mentioned photosensor 200 is connected to the gate line 1, the first power supply line 3 and the second power supply line 9 as shown in Fig. 6A. By use of these connections, the first power supply terminal T1 of the photosensor 200 can use the power source PV of the display unit 21, and the second power supply terminal T2 of the photosensor 200 can use the potential of the second power supply line 9. As described above, the second power supply line 9 is a power supply line with lower potential than that of the first power supply line 3. Moreover, by connecting to the gate line 1, the input signals (the voltage Vpulse) of the photosensor 200 can use the gate signals of the display unit 21 in common. Incidentally, the output voltage Vout is outputted to the sensor output line 8. Therefore, even if the photosensor (photoreceptor circuit) 200 is disposed in each of the pixel 30, it can be avoided to make wiring complex.

Furthermore, by adjusting the gate voltage Va of the TFT 203 to be a resistor, the sensitivity of detecting the output voltage Vout of the photosensor 200 can be changed.

Especially, since the photocurrent is a dark current of the phototransistor 205, variations in its values occur. However, since the sensitivity of detecting the output voltage Vout can be adjusted by use of the gate voltage Va of the resistor 203, the detection sensitivity of the photosensor 200 can be stabilized in each of the light emitting pixel 30. Therefore, the variations in a detection result lessen, and it is possible to reduce the unevenness of brightness.

In this embodiment, the V scanner 23 applies a gate signal to the gate lines 1 one by one. The gate signal is either an ON signal (H level) or an OFF signal (L level) and becomes an input signal Vpulse for the photosensor 200. When the V scanner applies the ON signal to one of the gate lines 1, all the selection TFTs connected with the selected gate line 1 turn on. At the same time, the first switching transistors 201 connected with the selected gate line 1 receive the ON signal to turn on the photosensors 200. The H scanner 22 applies the data signal Vdata to the drain lines 22 one by one so that the EL elements 7 emit light.

The photosensor 200 measures the light emitted from the EL element 7 and outputs the output voltage Vout to the brightness adjustment controller 51 through the sensor output line 8. The brightness controller 51 calculates the correction value, and the display data correction circuit 53 uses this correction value to modify the data signal Vdata supplied to the drain lines 2 so as to adjust the brightness of the EL element 7.

After the H scanner 22 applies the data signal Vdata to all the drain lines 2, the V scanner 23 applies the gate signal Vpulse to the next gate line 1. Thus, in this embodiment, the brightness of each of the EL elements 7 is measured separately and adjusted separately.

Moreover, with the above photosensor 200, the detection sensitivity can be adjusted by use of not only the Va value of the resistor 203 but the number of connections of the phototransistor 205, the intervals for the input signals (voltages) Vpulse or the capacitance of the capacitor 204. The number of connections of the phototransistor 205 contributes to the amount of the discharge of when the light of the organic EL element is sensed, and the intervals of the input signals Vpulse contribute to the period during which the output voltage Vout stays at H level as shown in Fig. 8. Further, the capacitance of the capacitor 204 is a potential to be applied to the gate electrode of the second switching transistor 202, and the potential is changed by discharging the electric charges from the capacitor 204 due to the relation of V = Q/C. That is, the smaller capacitance of the capacitor 204 can make the detection sensitivity increase.

Note that the circuit configuration shown in Fig. 7 is an example, and the connection position of the first switching transistor 201 and the phototransistor 205, the connection position of the second switching transistor 202 and the resistor 203 and the connection positions of the capacitor 204 can be changed. In other words, it is sufficient if the circuit is configured such that: the first switching transistor 201 is brought into conduction, thus charging the potential of the first connection point n1 with the potential of the first power supply terminal T1 or second power supply terminal T2; the first switching transistor 201 is cut off, thus changing the potential of the first connection point n1 by use of the discharge from the phototransistor 205; and the second switching transistor 202 is brought into conduction or is cut off by use of the potential of the first connection point n1, thus detecting the output voltage from the second connection point n2 of the second switching transistor 202 and the resistor 203.

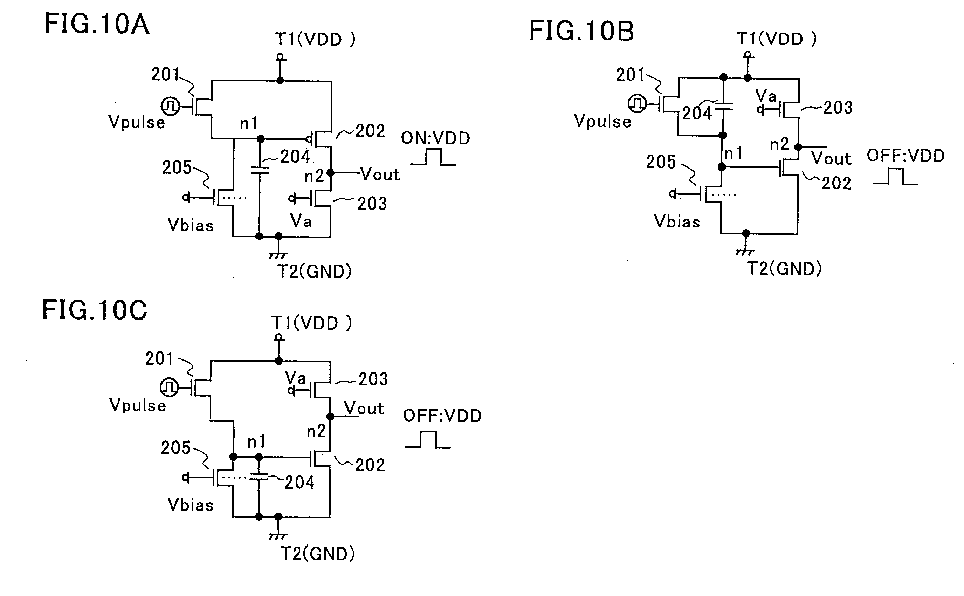

In Figs. 10A to 11D, another configuration of a light quantity detection circuit in Fig. 7 is shown. First, Fig. 10 shows a circuit which can detect the output voltage Vout at a potential close to that of the first power supply potential VDD.

Fig. 10A: the first switching transistor 201 is connected in series to the phototransistor 205, and is connected between the first power supply terminal T1 and the second power supply terminal T2. The second switching transistor 202 and the resistor 203 are connected in series, and they are also connected between the first power supply terminal T1 and the second power supply terminal T2. The second switching transistor 202 is a p-channel type TFT, and the resistor 203 is an n-channel type TFT. The capacitor 204 is connected in parallel to the phototransistor 205. One terminal of the capacitor 204 is connected to the control terminal of the second switching transistor 202 through the first connection point n1, and the other terminal is connected to the second power supply terminal T2.

Pulses of a predetermined voltage Vpulse (H level) are inputted to the control terminal, that is, the gate electrode, of the first switching transistor 201 for a certain period of time. While the H level pulses are being inputted, the conduction of the first switching transistor 201 is maintained. With this, the capacitor 204 is charged with electric charges of the power supply potential VDD.

When the pulses fall to L level (0 V), the first switching transistor 201 is cut off. When the phototransistor 205 is irradiated with light, the electric charges are discharged from the phototransistor 205 depending on the light quantity, and the standard potential (VDD) of the first connection point n1 decreases.

The second switching transistor 202 is brought into conduction after the potential of the first connection point n1 falls to under the threshold voltage VTH. Therefore, the resistance value of the second switching transistor 202 becomes sufficiently smaller than that of the resistor 203, thus bringing the potential of the second connection point n2 close to that of the first power supply terminal T1. Specifically, by bringing the second switching transistor 202 into conduction, the output voltage Vout can be outputted at a potential close to the power supply potential VDD by use of the photocurrent detected at the phototransistor 205 as a divided voltage of a potential difference between the power supply potential VDD and the ground potential GND.

Fig. 10B: the first switching transistor 201 is connected in series to the phototransistor 205, and is connected between the first power supply terminal T1 and the second power supply terminal T2. The second switching transistor 202 and the resistor 203 are connected in series, and they are also connected between the first power supply terminal T1 and the second power supply terminal T2. The second switching transistor 202 is an n-channel type TFT, and the resistor 203 is also an n-channel type TFT. The capacitor 204 is connected in parallel to the first switching transistor 201. One terminal of the capacitor 204 is connected to the control terminal of the second switching transistor 202 through the first connection point n1, and the other terminal is connected to the first power supply terminal T1.

Pulses of a predetermined voltage Vpulse (H level) are inputted to the control terminal, that is, the gate electrode, of the first switching transistor 201 for a certain period of time. While the H level pulses are being inputted, the conduction of the first switching transistor 201 is maintained. With this, the capacitor 204 is charged with electric charges of the power supply potential VDD.

When the pulses fall to L level (0 V), the first switching transistor 201 is cut off. When the phototransistor 205 is irradiated with light, the electric charges are discharged from the phototransistor 205 depending on the light quantity, the standard potential (VDD) of the first connection point n1 decreases.

The second switching transistor 202 of an n-channel type TFT is in conduction from a time to start the conduction of the first switching transistor 201 to a time to reach the threshold voltage VTH by decreasing the potential of the first connection point n1. That is, while the second switching transistor 202 is in conduction, the resistance value of the second switching transistor 202 becomes sufficiently smaller than that of the resistor 203, thus bringing the potential of the second connection point n2 close to that of the second power supply terminal T2. On the other hand, when the potential falls to under the threshold voltage VTH, the second switching transistor 202 is cut off. Therefore, the resistance value of the second switching transistor 202 becomes sufficiently larger than that of the resistor 203, thus bringing the potential of the second connection point n2 close to that of the first power supply terminal T1. In other words, by cutting off the second switching transistor 202, the output voltage Vout can be outputted at a potential close to the power supply potential VDD by use of the photocurrent detected at the phototransistor 205 as a divided voltage of a potential difference between the power supply potential VDD and the ground potential GND.

Fig. 10C: the first switching transistor 201 is connected in series to the phototransistor 205, and is connected between the first power supply terminal T1 and the second power supply terminal T2. The second switching transistor 202 and the resistor 203 are connected in series, and they are also connected between the first power supply terminal T1 and the second power supply terminal T2. The second switching transistor 202 is an n-channel type TFT, and the resistor 203 is also an n-channel type TFT. The capacitor 204 is connected in parallel to the phototransistor 205. One terminal of the capacitor 204 is connected to the control terminal of the second switching transistor 202 through the first connection point n1, and the other terminal is connected to the second power supply terminal T2.

Pulses of a predetermined voltage Vpulse (H level) are inputted to the control terminal, that is, the gate electrode, of the first switching transistor 201 for a certain period of time. While the H level pulses are being inputted, the conduction of the first switching transistor 201 is maintained. With this, the capacitor 204 is charged with electric charges of the power supply potential VDD.

When the pulses fall to L level (0 V), the first switching transistor 201 is cut off. When the phototransistor 205 is irradiated with light, the electric charges are discharged from the phototransistor 205 depending on the light quantity, the standard potential (VDD) of the first connection point n1 decreases.

The second switching transistor 202 of an n-channel type TFT is in conduction from a time to start the conduction of the first switching transistor 201 to a time to reach the threshold voltage VTH by decreasing the potential of the first connection point n1. That is, while the second switching transistor 202 is in conduction, the resistance value of the second switching transistor 202 becomes sufficiently smaller than that of the resistor 203, thus bringing the potential of the second connection point n2 close to that of the second power supply terminal T2. On the other hand, when the potential falls to under the threshold voltage VTH, the second switching transistor 202 is cut off. Therefore, the resistance value of the second switching transistor 202 becomes sufficiently larger than that of the resistor 203, thus bringing the potential of the second connection point n2 close to that of the first power supply terminal T1. In other words, by cutting off the second switching transistor, the output voltage Vout can be detected at a potential close to the power supply potential VDD.

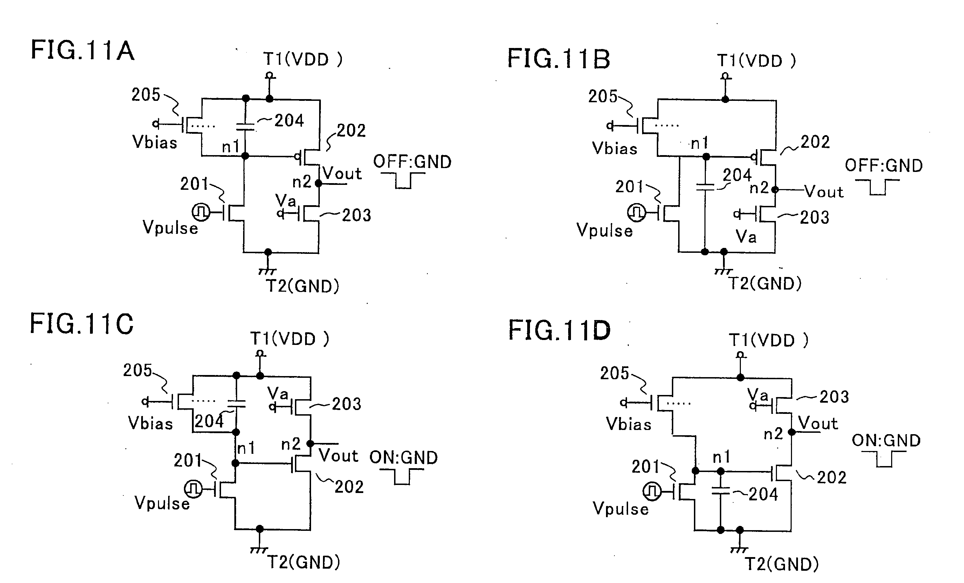

Figs. 11A to 11D show structures in which the connections of the first switching transistor 201 and the phototransistor 205 of Figs. 7 and 10A to 10C are replaced. By use of this structure, the output voltage Vout can be detected at a potential close to that of the second power supply terminal T2.

Fig. 11A: the first switching transistor 201 is connected in series to the phototransistor 205, and is connected between the first power supply terminal T1 and the second power supply terminal T2. The second switching transistor 202 and the resistor 203 are connected in series, and they are also connected between the first power supply terminal T1 and the second power supply terminal T2. The second switching transistor 202 is a p-channel type TFT, and the resistor 203 is an n-channel type TFT. The capacitor 204 is connected in parallel to the phototransistor 205. One terminal of the capacitor 204 is connected to the control terminal of the second switching transistor 202 through the first connection point n1, and the other terminal is connected to the first power supply terminal T1.

Pulses of a predetermined voltage Vpulse (H level) are inputted to the control terminal, that is, the gate electrode, of the first switching transistor 201 for a certain period of time. While the H level pulses are being inputted, the conduction of the first switching transistor 201 is maintained. With this, the capacitor 204 is charged with electric charges of the ground potential GND.

When the pulses fall to L level (0 V), the first switching transistor 201 is cut off. When the phototransistor 205 is irradiated with light, the electric charges are discharged from the phototransistor 205 depending on the light quantity, the standard potential (GND) of the first connection point n1 increases.

The second switching transistor 202 of a p-channel type TFT is in conduction from a time to start the conduction of the first switching transistor 201 to a time to reach the threshold voltage VTH by decreasing the potential of the first connection point n1. Consequently, when the second switching transistor 202 is in conduction, the potential of the second connection point n2 draws close to that of the first power supply terminal T1. On the other hand, when the potential of the first connection point n1 rises to over the threshold voltage, the second switching transistor 202 is cut off. Therefore, the potential of the second connection point n2 draws close to that of the second power supply terminal T2. In other words, by cutting off the second switching transistor 202, the output voltage Vout can be detected at a potential close to the ground potential GND.

Fig. 11B: the first switching transistor 201 is connected in series to the phototransistor 205, and is connected between the first power supply terminal T1 and the second power supply terminal T2. The second switching transistor 202 and the resistor 203 are connected in series, and they are also connected between the first power supply terminal T1 and the second power supply terminal T2. The second switching transistor 202 is a p-channel type TFT, and the resistor 203 is an n-channel type TFT. The capacitor 204 is connected in parallel to the first switching transistor 201. One terminal of the capacitor 204 is connected to the control terminal of the second switching transistor 202 through the first connection point n1, and the other terminal is connected to the second power supply terminal T2.

Pulses of a predetermined voltage Vpulse (H level) are inputted to the control terminal, that is, the gate electrode, of the first switching transistor 201 for a certain period of time. While the H level pulses are being inputted, the conduction of the first switching transistor 201 is maintained. With this, the capacitor 204 is charged with electric charges of the ground potential GND.

When the pulses fall to L level (0 V), the first switching transistor 201 is cut off. When the phototransistor 205 is irradiated with light, the electric charges are discharged from the phototransistor 205 depending on the light quantity, the standard potential (GND) of the first connection point n1 increases.

The second switching transistor 202 of a p-channel type TFT is in conduction from a time to start the conduction of the first switching transistor 201 to a time to reach the threshold voltage VTH by increasing the potential of the first connection point n1. Consequently, when the second switching transistor 202 is in conduction, the potential of the second connection point n2 draws close to that of the first power supply terminal T1. On the other hand, when the potential of the first connection point n1 rises to over the threshold voltage VTH, the second switching transistor 202 is cut off. Therefore, the potential of the second connection point n2 draws close to that of the second power supply terminal T2. In other words, by cutting off the second switching transistor 202, the output voltage Vout can be detected at a potential close to the ground potential GND.

Fig. 11C: the first switching transistor 201 is connected in series to the phototransistor 205, and is connected between the first power supply terminal T1 and the second power supply terminal T2. The second switching transistor 202 and the resistor 203 are connected in series, and they are also connected between the first power supply terminal T1 and the second power supply terminal T2. The second switching transistor 202 is an n-channel type TFT, and the resistor 203 is also an n-channel type TFT. The capacitor 204 is connected in parallel to the phototransistor 205. One terminal of the capacitor 204 is connected to the control terminal of the second switching transistor 202 through the first connection point n1, and the other terminal is connected to the first power supply terminal T1.

Pulses of a predetermined voltage Vpulse (H level) are inputted to the control terminal, that is, the gate electrode, of the first switching transistor 201 for a certain period of time. While the H level pulses are being inputted, the conduction of the first switching transistor 201 is maintained. With this, the capacitor 204 is charged with electric charges of the ground potential GND.

When the pulses fall to L level (0 V), the first switching transistor 201 is cut off. When the phototransistor 205 is irradiated with light, the electric charges are discharged from the phototransistor 205 depending on the light quantity, the standard potential (GND) of the first connection point n1 increases.

The second switching transistor 202 of an n-channel type TFT is being cut off until the potential of the first connection point n1 reaches the threshold voltage VTH, and when the potential rises to over the threshold voltage VTH, the second switching transistor 202 is brought into conduction. The potential of the second connection point n2 draws close to that of the first power supply terminal T1 while the second switching transistor 202 is being cut off. When the second switching transistor 202 is brought into conduction, the potential of the second connection point n2 draws closer to that of the second power supply terminal T2. In other words, the output voltage Vout can be outputted at a potential close to the ground potential GND by bringing the second switching transistor 202 into conduction.

Fig. 11D: the first switching transistor 201 is connected in series to the phototransistor 205, and is connected between the first power supply terminal T1 and the second power supply terminal T2. The second switching transistor 202 and the resistor 203 are connected in series, and they are also connected between the first power supply terminal T1 and the second power supply terminal T2. The second switching transistor 202 is an n-channel type TFT, and the resistor 203 is also an n-channel type TFT. The capacitor 204 is connected in parallel to the first switching transistor 201. One terminal of the capacitor 204 is connected to the control terminal of the second switching transistor 202 through the first connection point n1, and the other terminal is connected to the second power supply terminal T2.

Pulses of a predetermined voltage Vpulse (H level) are inputted to the control terminal, that is, the gate electrode, of the first switching transistor 201 for a certain period of time. While the H level pulses are being inputted, the conduction of the first switching transistor 201 is maintained. With this, the capacitor 204 is charged with electric charges of the ground potential GND.

When the pulses fall to L level (0 V), the first switching transistor 201 is cut off. When the phototransistor 205 is irradiated with light, the electric charges are discharged from the phototransistor 205 depending on the light quantity, the standard potential (GND) of the first connection point n1 increases.

The second switching transistor 202 of an n-channel type TFT is being cut off until the potential of the first connection point n1 reaches the threshold voltage VTH, and when the potential rises to over the threshold voltage VTH, the second switching transistor 202 is brought into conduction. The potential of the second connection point n2 draws close to that of the first power supply terminal T1 while the second switching transistor 202 is being cut off. When the second switching transistor 202 is brought into conduction, the potential of the second connection point n2 draws closer to that of the second power supply terminal T2. In other words, the output voltage Vout can be outputted at a potential close to the ground potential GND by bringing the second switching transistor 202 into conduction.

In addition, although the illustration will be omitted, a resistive element can be connected as the resistor 203. The resistive element is formed by doping, for example, polysilicon, ITO or the like with an n-type impurity, and has a high resistance value of approximately 10³ Ω to 10⁸ Q. In this case, by changing the resistance value of the resistive element 203, the condition becomes the same as a condition in which the constant value Va of the above-described circuit is changed. Thus, the sensitivity of the photosensor 200 can be adjusted.

As described above, the second switching transistor 202 in this embodiment uses a p-channel type TFT if one terminal of the second switching transistor 202 is connected to the first power supply terminal T1 with a high potential as shown in Fig. 7, 10A, 11A or 11B. To the contrary, the second switching transistor 202 uses an n-channel type TFT if one terminal of the second switching transistor 202 is connected to the second power supply terminal T2 with a low potential as shown in Fig. 10B, 10C, 11C or 11D.

Moreover, if the photoreceptor circuit 200 is connected to the light emitting circuit 180 as shown in Fig. 6A, the first power supply terminal T1 and the second power supply terminal T2 are connected to any one of the first power supply line 3 and the second power supply line 9, respectively. It is sufficient for a potential in one of the light emitting pixel 30 if a relation where the PV power source is larger than the CV power source is viable. Hence, depending on the potential relation between the first power supply line 3 and the second power supply line 9, the circuit is suitably selected from Figs. 7, 10A to 10C and 11A to 11D.

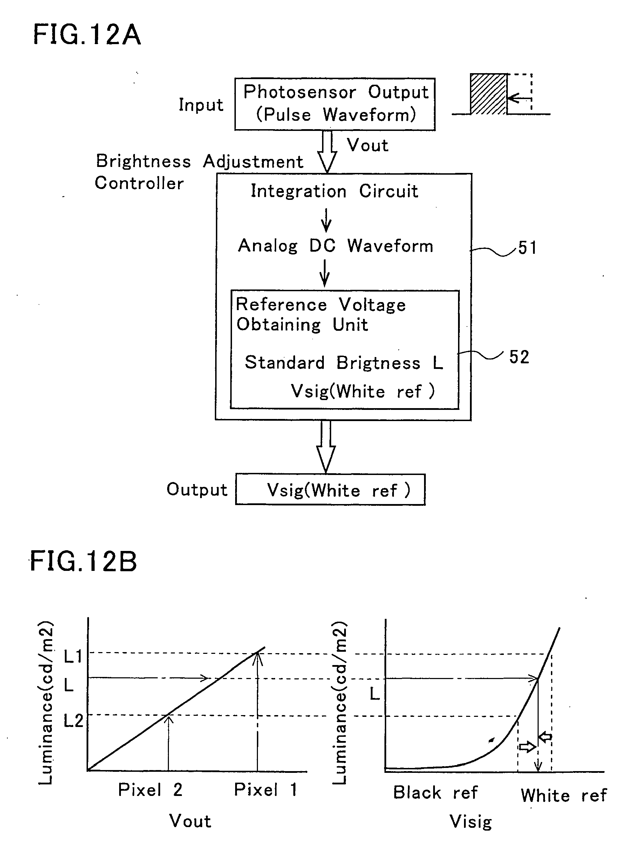

Figs. 12A to 12B are explanatory views for the brightness adjustment controller 51. Fig. 12A is a block diagram, and Fig. 12B is an example of a graph of characteristics held by the reference voltage obtaining unit 52.

A detection result (the output voltage Vout depending on the brightness of each of the light emitting pixel 30) of the photosensor 200 is inputted to the brightness adjustment controller 51. Note that the photosensors (photoreceptor circuits) 200 in the second embodiment have different timings of being on depending on their brightness, and analog values can be obtained by integrating the area of a pulse part to be on.

Specifically, pulse waveforms are inputted to the brightness adjustment controller 51 as shown in Fig. 12A. The pulse waveforms are integrated to calculate their areas in the integration circuit in the brightness adjustment controller 51. Thus, the analog DC waveforms are obtained.

In the reference voltage obtaining unit 52, by use of the characteristics diagram similar to the left graph of Fig. 12B, the brightness of the light emitting pixels 30 are calculated depending on the output voltage Vout of the photosensor 200, which are compared to the standard brightness L. For example, a pixel 1 is required to make its brightness low to be the standard brightness L, and a pixel 2 is required to make its brightness high. In addition, since there is a relation similar to the right graph of Fig. 12B between the brightness and the reference voltage, the reference voltage adjusted to have the standard brightness L in each of the pixel 30 is obtained as a correction value Vsig. The correction value Vsig is outputted to the grayscale standard voltage generation circuit 54.

The standard brightness L may be an average of all of the light emitting pixels 30, or the brightness adjusted to that of a pixel to have a small luminous brightness, for example. Otherwise, the standard brightness L may be set in advance.

Furthermore, the correction value Vsig may be found by obtaining a white reference voltage value corresponding to the standard brightness L, or an adjusted value to have the white reference voltage corresponding to the standard brightness L may be found for each of the pixel 30, thus outputting the values as the correction values Vsig.

The correction value Vsig outputted from the brightness adjustment controller 51 is used as the white reference voltage of the grayscale standard voltage generation circuit 54. Subsequently, a gamma correction is performed on the correction value Vsig at the gamma correction circuit 55, which is transmitted to the display unit 21 as the data signal Vdata of the drain line 2 (see Fig. 5).

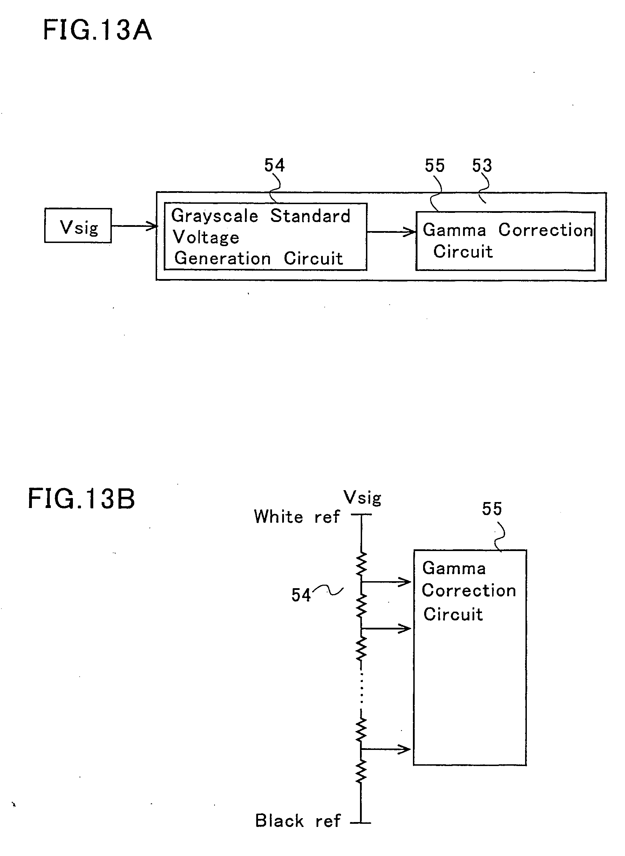

Figs. 13A and 13B are explanatory views of the display data correction circuit 53. Fig. 13A is a block diagram, and Fig. 13B is a circuit diagram of the grayscale standard voltage generation circuit 54.

The display data correction circuit 53 includes the grayscale standard voltage generation circuit 54 and the gamma correction circuit 55. The correction value Vsig outputted in a manner as has already been mentioned is inputted to the grayscale standard voltage generation circuit 54.

The grayscale standard voltage generation circuit 54 is a resistance divider circuit where resistances are connected in series. The number of the resistances corresponds to the number of grayscale (256). The white reference voltage (white ref) is a reference voltage at low potential to be the highest brightness level (white) of the EL element 7 of the pixel 30. The black reference voltage (black ref) is a reference voltage at high potential to be the lowest brightness level (black) of the El element 7 of the pixel 30.

In this embodiment, in this circuit, the black reference voltage is fixed, and the correction value Vsig is used as the white reference voltage of the grayscale standard voltage generation circuit 54. For example, if the white reference voltage value corresponding to the standard brightness L is outputted as the correction value Vsig, the outputted value is set. Further, if the adjusted value in relation to the white reference voltage corresponding to the standard brightness L is outputted as the correction value Vsig, the white reference voltage is changed by use of the correction value Vsig.

A description will be given of a reason to change the white reference voltage. A contrast CR is a difference between the brightnesses of black and white. Upon shipping the products, the contrast CR is adjusted to be obtained sufficiently (that is, black can be sufficiently viewable as "black") in an indoor environment.

In other words, the brightness of black is sufficiently low, and its value is close to 0. Therefore, the brightness of white is adjusted to adjust the brightness, which can be realized by changing the white reference voltage.

The grayscale standard voltage generation circuit 54 generates a grayscale display voltage between the corrected white reference voltage (Vsig) and the black reference voltage (fixed value).

An analog voltage for a grayscale display (grayscale display voltage) of 256 kinds, which is generated at the grayscale standard voltage generation circuit 54, is outputted as a data signal for each of R, G and B through the gamma correction circuit 55 and the gate signal line to the light emitting pixel 30 in the display unit 21.

As described above, the descriptions have been given of the example to correct the brightness of each of the light emitting pixel 30, which can be also utilized for the adjustment of a brightness half-life.

Figs. 14A and 14B are characteristics diagrams showing a relation between the brightness of the organic EL element 7 and time. As shown in figures, the organic EL element 7 has a brightness half-life. When the brightnesses of all the light emitting pixels 30 are lower than that upon shipping the products (L to L3) due to the second embodiment, their brightness half-lives can be extended by topping up the white reference voltage for the loss caused by the degradation by use of the correction Vsig as shown in Fig. 14B. Accordingly, it is possible to contribute to making an organic EL display device last longer.

Furthermore, both of the correction of brightness and the adjustment of a brightness half-life may be performed at the same time. Thus, it is possible to provide a long-life organic EL display device with a good display quality.

Note that in this embodiment it is also possible to implement the present invention even if the pixel 30 has a top emission structure to emit light upward in the page space by reversing the stacking order of the organic EL layer 76, the anode 71 and the cathode 75 in Fig. 4B. However, even in that case, it is advantageous for the photosensors 100 and 200 to have a bottom gate structure.

## Claims

1. An organic electroluminescent display device comprising:
- a plurality of drain lines (2) and a plurality of gate lines (1) disposed in a matrix form on a substrate (10);
- a plurality of light emitting pixels (30) disposed on the substrate (10) in accordance with the matrix form of the drain lines (2) and the gate lines (1), each of the light emitting pixels (30) comprising a drive transistor (6), a selection transistor (4) and an organic electroluminescent element (7); and
- a plurality of photosensors (100, 200) disposed on the substrate (10) and each provided for corresponding light emitting pixels (30) to measure brightness of corresponding organic electroluminescent elements (7).

2. The display device of claim 1, wherein each of the photosensors (100, 200) covers part of a corresponding organic electroluminescent element.

3. An organic electroluminescent display device comprising:
- a plurality of drain lines (2) and a plurality of gate lines (1) disposed in a matrix form on a substrate (10);
- a plurality of light emitting pixels (30) disposed on the substrate (10) in accordance with the matrix form of the drain lines (2) and the gate lines (1), each of the light emitting pixels (30) comprising a drive transistor (6), a selection transistor (4) and an organic electroluminescent element (7); and
- a photosensor (100) disposed in each of the light emitting pixels (30) and comprising a photosensor transistor, a gate (101) of the photosensor transistor receiving a constant voltage, a source (103s) or a drain (103d) of the photosensor transistor being connected with a power supply terminal (PV) of the drive transistor (6), and the source (103s) or the drain (103d) of the photosensor transistor that is not connected with the power supply terminal (PV) being connected with a control terminal (VG) of the drive transistor (6).

4. The display device of claim 3, wherein the photosensor covers part of a corresponding organic electroluminescent element (7).

5. The display device of claim 3, wherein the organic electroluminescent element (7) is configured to receive less current when the photosensor (100) receives more light from the organic electroluminescent element (7).

6. The display device according to any of claims 3 to 5, wherein the photosensor transistor is a thin film transistor comprising the gate (101), an insulation film (12) and a semiconductor layer (103) stacked on the substrate (10), the thin film transistor further comprising a channel (103c) provided in the semiconductor layer (103), the source (103s) formed at one end of the channel (103c) and the drain (103d) formed at another end of the channel (103c) and converting light incident thereon into an electric signal.

7. The display device of claim 6, wherein the semiconductor layer is configured to receive the light in a junction region between the source (103s) and the channel (103c) of the or between the drain (103d) and the channel (103c).

8. The display device of claim 6 or 7, wherein a low concentration impurity region (103LD) is provided between the source (103s) and the channel (103c) or between the drain (103d) and the channel (103c).

9. The display device of claim 8, wherein the low concentration impurity region (103LD) is provided on a side of the semiconductor layer (103) outputting a photocurrent generated by incident light.

10. An organic electroluminescent display device comprising:
- a plurality of drain lines (2) and a plurality of gate lines (1) disposed in a matrix form on a substrate (10);
- a plurality of light emitting pixels (30) disposed on the substrate (10) in accordance with the matrix form of the drain lines (2) and the gate lines (1), each of the light emitting pixels (30) comprising a drive transistor (6), a selection transistor (4) and an organic electroluminescent element (7); and
- a photosensor (200) disposed in each of the light emitting pixels (30) and measuring brightness of a corresponding organic electroluminescent element (7), the photosensor being configured to change a photosensitivity thereof.

11. The display device of claim 10, wherein the photosensor (200) covers part of a corresponding organic electroluminescent element (7).

12. The display device of claim 10 or 11, wherein a reference voltage of data signals supplied to the drain lines (2) is selected based on the measured brightness.

13. The display device of claim 10, wherein the photosensor (200) comprises:
- a thin film transistor (205) converting light incident thereon into an electric signal,
- a first power supply line (3) supplying a high potential and a second power supply line (9) supplying a low potential,
- a first switching transistor (201) connected with the thin film transistor (205) in series between the first power supply line (3) and the second power supply line (9),
- a second switching transistor (202) connected with a resistor (203) in series between the first power supply line (3) and the second power supply line (9), and
- a capacitor (204), a first capacitor terminal of the capacitor (204) being connected with a control terminal of the second switching transistor (202) and a second capacitor terminal of the capacitor (204) being connected with the first power supply line (3) or the second power supply line (9).

14. The display device of claim 13, wherein the first power supply line (3) is connected to the drive transistor (6).

15. The display device of claim 13 or 14, wherein the thin film transistor (205) comprises a gate (101), an insulation film (12) and a semiconductor layer (103) stacked on the substrate (10) and further comprises a channel (103c) provided in the semiconductor layer (103), a source (103s) formed at one end of the channel (103c) and a drain (103d) formed at another end of the channel (103c), and the semiconductor layer (103) is configured to receive the light in a junction region between the source (103s) and the channel (103c) or between the drain (103d) and the channel (103c).

16. The display device of claim 13 or 14, wherein the thin film transistor (205) comprises a gate (101), an insulation film (102) and a semiconductor layer (103) stacked on the substrate (10) and further comprises a channel (103c) provided in the semiconductor layer (103), a source (103s) formed at one end of the channel (103c) and a drain (103d) formed at another end of the channel (103c), and a low concentration impurity region (103LD) is provided between the source (103s) and the channel (103c) or between the drain (103d) and the channel (103c).

17. The display device of claim 16, wherein the low concentration impurity region (103LD) is provided on a side of the semiconductor layer (103) outputting a photocurrent generated by incident light.
